# EUROPÄISCHE PATENTSCHRIFT

(11) **EP 3 127 405 B1**
(45) Veröffentlichungstag und Bekanntmachung des Hinweises auf die Patenterteilung: **19.10.2022**
(21) Anmeldenummer: 15715131.7
(22) Anmeldetag: 25.03.2015
(51) Int. Cl.: H05K 1/18, H05K 1/02, G02B 6/43

(54) **VERFAHREN ZUR HERSTELLUNG EINER LEITERPLATTE MIT ZUMINDEST EINER OPTOELEKTRONISCHEN KOMPONENTE**
METHOD FOR PRODUCING A CIRCUIT BOARD HAVING AT LEAST ONE OPTOELECTRONIC COMPONENT
PROCÉDÉ DE FABRICATION D'UNE CARTE DE CIRCUIT IMPRIMÉ ÉQUIPÉE D'AU MOINS UN COMPOSANT OPTOÉLECTRONIQUE

(30) Priorität: 31.03.2014 AT 502302014
(43) Veröffentlichungstag der Anmeldung: 08.02.2017
(73) Patentinhaber: AT & S Austria Technologie & Systemtechnik Aktiengesellschaft, 8700 Leoben (AT)
(72) Erfinder: LANGER, Gregor, 9061 Wölfnitz (AT)
(74) Vertreter: Patentanwaltskanzlei Matschnig & Forsthuber OG
(86) Internationale Anmeldenummer: PCT/AT2015/050077
(87) Internationale Veröffentlichungsnummer: WO 2015/149097

(56) Entgegenhaltungen:
- WO-A1-2013/029073
- DE-A1-102008 019 902
- DE-A1-102010 040 011
- US-A1- 2010 209 041
- US-A1- 2011 064 362
- US-A1- 2011 225 816

## Beschreibung

Die vorliegende Erfindung betrifft ein Verfahren zur Herstellung einer Leiterplatte mit zumindest einer optoelektronischen Komponente.

Leiterplatten werden in der elektronischen Industrie zum hochintegrierten Verschalten elektronischer Komponenten verwendet. Die immer weiter voranschreitende Miniaturisierung elektronischer Geräte erfordert es hierbei zunehmend, elektronische Komponenten nicht nur auf der Oberfläche einer Leiterplatte anzuordnen, sondern die Komponenten auch ins Innere, d.h. in den Querschnitt der Leiterplatte zu integrieren. Die Integration von elektronischen Komponenten in das Innere von Leiterplatten führt zum einen zu besonders kompakten Konfigurationen und bietet zum anderen den verbauten Komponenten einen erhöhten mechanischen und chemischen Schutz. Während die Integration von elektronischen Komponenten im industriellen Maßstab in das Innere von Leiterplatten bei einer Reihe von elektronischen Komponenten bereits standardmäßig durchgeführt wird, wurde bisher noch keine zufriedenstellende Methode gefunden, um auch optoelektronische Komponenten in den Querschnitt einer Leiterplatte zu integrieren. In Zusammenhang mit der vorliegenden Erfindung werden unter optoelektronischen Komponenten elektronische Komponenten verstanden, die Licht entweder aussenden bzw. emittieren (LED-Chip, Laserdiode) oder empfangen bzw. detektieren (Photodiode) oder die Licht zu Messzwecken reflektieren und messen (DLP-Bauteile (Digital Light Processing Bauteile)). Gemeinsam ist diesen optoelektronischen Komponenten, dass sie ihre Funktion nur erfüllen können, wenn Licht von ihnen abgestrahlt oder empfangen werden kann, weshalb die Integration solcher Komponenten in eine Leiterplatte einen optischen Signalweg zur Umgebung oder einfach gesprochen eine transparente Oberfläche der Leiterplatte im Bereich der optoelektronischen Komponente erfordert.

Aus dem Stand der Technik ist beispielsweise aus dem Dokument US 2011/0225816 A1 bereits ein Verfahren zur Herstellung einer Leiterplatte bekannt geworden, bei dem zumindest eine elektronische Komponente durch Einsatz einer Klebeschicht in einen Leiterplattenverbund eingebettet wird. Allerdings sind dort weder der Einsatz einer transparent aushärteten Klebeschicht, noch das Einbetten von optoelektronischen Komponenten mit einem darüberliegenden optischen Fensterelement, welches die optoelektronischen Komponenten schützt, bekannt geworden.

Das Dokument US 2010/0209041 betrifft ein Verfahren zum Einbetten eines elektronischen Bauteils in einer Ausnehmung einer isolierenden Materialschicht eines Core-Elements, wobei die Dicke des Core-Elements größer als die Bauhöhe der Komponente sein sollte. Das Bauteil wird dazu während des Einbaus temporär beispielsweise mit einer Klebefolie auf einer Trägerschicht befestigt. Anschließend wird der seitliche Freiraum zwischen dem Bauteil und dem Core-Element mit einem Kleber verfüllt und danach die Trägerschicht wieder entfernt. Das Bauteil ist daraufhin mit einer seiner Bauteilseiten bündig mit einer äußeren Schicht des Core-Elements in diesem eingebettet. Ein optisches Fensterelement zum Schutz des eingebetteten Bauteils ist aus der US 2010/0209041 nicht bekannt.

Aus dem Dokument WO 2013/029073 A1 ist eine Leiterplatte bekannt geworden, bei der eine optoelektronische Komponente im Inneren der Leiterplatte eingebettet sowie nach außen hin durch ein optisches Fensterelement bedeckt ist.

Das Dokument US 2011/064362 A1 betrifft ein Halbleiterelement, bei dem optoelektronische Bauteile und Wellenleiter in Kavitäten einer Leiterplatte eingesetzt werden.

Das Dokument DE 10 2010 040 011 A1 betrifft einen optischen Näherungssensor, bei dem auf einer fertigen Leiterplatte nachträglich auf deren Außenseite optoelektronische Komponenten wie ein Infrarotlichtemitter sowie ein Lichtdetektor bestückt werden, und diese Bauteile anschließend rundum in einem Mold-Material eingegossen werden.

DE 10 2008 019902 A1 zeigt ein optoelektronisches Bauelement, aufweisend ein Trägerelement, wenigstens zwei auf einer ersten Seite des Trägerelements benachbart angeordnete Elemente mit jeweils mindestens einem optisch aktiven Bereich zum Erzeugen elektromagnetischer Strahlung.

Die vorliegende Erfindung zielt auf die Schaffung eines industriell anwendbaren Verfahrens zu Herstellung einer transparenten Oberfläche im Bereich einer in eine Leiterplatte integrierten, optoelektronischen Komponente ab. Zur Lösung dieser Aufgabe ist ein Verfahren der eingangs genannten Art erfindungsgemäß durch die folgenden Schritte gekennzeichnet:
a) Aufbringen einer transparent aushärtbaren Klebeschicht auf eine Trägerschicht
b) Aufsetzen zumindest einer optoelektronischen Komponente mit einer optisch relevanten Seite der Komponente auf die Klebeschicht
c) Aushärten der Klebeschicht zu einem Fensterelement
d) Einbetten der Komponente in einen Leiterplattenverbund
e) Strukturieren der Trägerschicht zur zumindest teilweisen Freilegung des Fensterelements und zur Ankontaktierung der Komponente.

Bei dem erfindungsgemäßen Verfahren wird somit eine Klebeschicht, die durch weiter unten beschriebene Verfahren zu einem transparenten Fensterelement ausgehärtet werden kann, auf eine Trägerschicht aufgebracht, um die betreffende optoelektronische Komponente auf der Klebeschicht zu befestigen. Dadurch, dass eine klebende Schicht bereitgestellt wird, gelingt es, die optoelektronische Komponente im Bereich des zukünftigen Fensterelements zu fixieren, wobei die Komponente naturgemäß mit der optisch relevanten Seite auf die Klebeschicht gesetzt wird, sodass beim fertigen Produkt auch die optisch relevante Seite zum zukünftigen Fensterelement gewandt ist. Im Zusammenhang mit der vorliegenden Erfindung wird unter der optisch relevanten Seite einer optoelektronischen Komponente jene Seite der Komponente verstanden, die Licht entweder abstrahlt bzw. emittiert oder empfängt bzw. detektiert. Nach dem Aushärten der Klebeschicht zu einem transparenten Fensterelement kann der weitere Aufbau der Leiterplatte erfolgen, wofür herkömmliche Verfahren der Leiterplattentechnik eingesetzt werden können. Im Zusammenhang mit der vorliegenden Erfindung ist es jedoch klar, dass das aus der transparent aushärtbaren Klebeschicht entstandene Fensterelement in der Regel an der Oberfläche der Leiterplatte bleibt, um die optische Kommunikation der optoelektronischen Komponente mit der Umgebung der Leiterplatte zu ermöglichen. Abschließend wird die Trägerschicht strukturiert, um das Fensterelement, das sich nach dem Einbetten der Komponente im Leiterplattenverbund unter der Trägerschicht befindet, zumindest teilweise freizulegen und an die Oberfläche der Leiterplatte zu bringen, sodass die optoelektronische Komponente mit der Umgebung der Leiterplatte durch die Aussendung und/oder den Empfang von Licht optisch kommunizieren kann.

Gemäß einer bevorzugten Ausführungsform der vorliegenden Erfindung ist das Verfahren dahingehend weitergebildet, dass die optoelektronische Komponente aus der Gruppe bestehend aus einer Laserdiode, einer LED, einer Photodiode und einem DLP-Bauteil gewählt wird.

Bevorzugt wird das Material für die transparent aushärtbare Klebeschicht aus der Gruppe bestehend aus Epoxidharz, Polysiloxan, Ormocer und Lötstopplack gewählt. Diese Materialien werden in der Leiterplattentechnik bereits standardmäßig eingesetzt und ihre Verarbeitung ist dem Fachmann daher geläufig. Neben der Klebrigkeit dieser Materialien im nicht ausgehärteten Zustand sind eine lange Haltbarkeit und eine hohe Transparenz nach der Aushärtung von Vorteil, um mit der vorliegenden Erfindung hochtransparente Fensterelemente für in eine Leiterplatte integrierte optoelektronische Komponenten zu schaffen.

Die vorgenannten Materialien gestatten die Ausbildung eines überaus dünnen Fensterelements, so dass es bereits ausreichend ist, wenn die Klebeschicht mit einer Dicke von 5 µm bis 50 µm aufgebracht wird. Das Aufbringen einer derart dünnen Klebeschicht auf die Trägerschicht erlaubt es auch, hohle und zumindest einseitig offene optoelektronische Komponenten wie DLP-Bauteile mit gegebenenfalls beweglichen, insbesondere oszillierenden Spiegeln auf die Klebeschicht aufzusetzen, ohne dass die Bewegung des Spiegels durch die Klebeschicht und in der Folge durch das Fensterelement eingeschränkt wird.

Bevorzugt ist die Erfindung dahingehend weitergebildet, dass das Aufbringen der Klebeschicht mit einem Verfahren erfolgt, welches aus der Gruppe bestehend aus Siebdruck-Verfahren, Inkjet-Verfahren und Rakel-Verfahren gewählt wird. Diese Verfahren sind im Stand der Technik bestens bekannt und werden vom Fachmann gut beherrscht.

Gemäß einer bevorzugten Ausführungsform der vorliegenden Erfindung ist die Trägerschicht von einer Kupferlage mit einer Dicke von 1 µm bis 5 µm, insbesondere 2 µm gebildet. Wenn eine Kupferlage mit der genannten Dicke als Trägerschicht verwendet wird, kann diese Kupferlage nach dem Einbetten der Komponente zur Freilegung des Fensterelements im Bereich des Fensterelements durch Strukturieren entfernt werden, was bei Verwendung von Kupfer durch herkömmliche Leiterplattenprozesse vonstatten gehen kann. Insbesondere kann die Trägerschicht aus Kupfer in der Folge z.B. durch photolithographische Verfahren zu Leiterzügen strukturiert und zur Ankontaktierung bzw. Entflechtung der optoelektronischen Komponente genützt werden.

Kupferlagen mit Dicken von beispielsweise 2 µm sind als solche in der industriellen Produktion relativ schwer zu handhaben, da sie leicht knicken oder reißen. Gemäß einer bevorzugten Ausführungsform ist das erfindungsgemäße Verfahren daher dahingehend weitergebildet, dass die Trägerschicht zumindest beim Schritt des Aufbringens der transparent aushärtbaren Klebeschicht der Komponente mit einer Stützschicht verbunden ist, welche in einem späteren Verfahrensschritt entfernt wird, wenn beispielsweise nach dem Einbetten der Komponente in einen Leiterplattenverbund der Leiterplattenverbund genügend Stabilität zur problemlosen Handhabung eines Leiterplattenzwischenprodukts zur Verfügung stellt.

Um eine möglichst schnelle Aushärtung der Klebeschicht zum Fensterelement zu gewährleisten, ist das erfindungsgemäße Verfahren bevorzugt dahingehend weitergebildet, dass das Aushärten der Klebeschicht unter Anwendung von UV-Licht und/oder erhöhter Temperatur ausgeführt wird.

Das Einbetten der Komponente bzw. der Komponenten in einen Leiterplattenverbund kann, wie bereits erwähnt, durch auf dem Gebiet der Leiterplattentechnik bekannte Prozesse erfolgen. Gemäß einer bevorzugten Ausführungsform kann dabei dergestalt vorgegangen werden, dass die Komponente in zumindest eine Lage aus einem glasfaserverstärkten Epoxidharz mit einer der Komponente entsprechenden Freistellung eingebettet wird. Dies ist insbesondere dann von Vorteil, wenn relativ dicke optoelektronische Komponenten verbaut werden, was ohne das Vorsehen von Ausnehmungen in glasfaserverstärktem Epoxidharz (Prepreg-Material) zu Unebenheiten der Leiterplatte führen würde. Im Normalfall wird die Komponente in eine Mehrzahl von übereinander liegenden Lagen aus einem glasfaserverstärkten Epoxidharz (Prepreg-Material) mit entsprechenden Freistellungen eingebettet.

Insbesondere bei der Verwendung von LED-Bauteilen ist es zur Realisierung von Weißlicht üblich, das Licht der LED auf Lichtkonversionsmittel, die im Stand der Technik auch Phosphore genannt werden, zu richten, um das Lichtkonversionsmittel mit dem LED anzuregen sodass Licht mit anderer Wellenlänge als der ursprünglichen Wellenlänge der LED abgestrahlt wird. In diesem Zusammenhang ist es daher bevorzugt vorgesehen, dass die transparent aushärtbare Klebeschicht vor dem Aufsetzen der Komponente mit einem Lichtkonversionsmittel versetzt wird. In diesem Fall ersetzt das beim Aushärten der Klebeschicht entstehende Fensterelement ein separates Bauteil mit einem Lichtkonversionsmittel, was wiederum der in der elektronischen Industrie angestrebten Miniaturisierung der Leiterplatten zuträglich ist.

Alternativ kann gemäß einer bevorzugten Ausführungsform jedoch auch dergestalt vorgegangen werden, dass nach dem Freilegen des Fensterelements eine transparente Schicht mit einem Lichtkonversionsmittel auf das Fensterelement aufgebracht wird. Optoelektronische Komponenten werden in zunehmendem Maße auch auf Leiterplattenebene für messtechnische Anwendungen herangezogen. Beispielsweise können flüssige Medien durch Beleuchten und Messen von gestreutem Licht oder durch Messen von Fluoreszenz in gewissem Umfang qualitativ und zumindest semiquantitativ analysiert werden. Hierzu werden die Medien beispielsweise mit einer LED beleuchtet und das gestreute Licht bzw. die entstehende Fluoreszenz mit einer Photodiode gemessen. Mit der vorliegenden Erfindung kann eine derartige Messanordnung auf überaus kleinem Raum untergebracht werden, wenn zumindest zwei optoelektronische Komponenten, insbesondere eine lichtemittierende und eine lichtdetektierende Komponente auf die Klebeschicht aufgesetzt werden, wie dies einer bevorzugten Ausführungsformen der vorliegenden Erfindung entspricht. Die lichtemittierende Komponente kann eine LED und die lichtdetektierende Komponente eine Photodiode sein, die bei dieser bevorzugten Ausführungsform des erfindungsgemäßen Verfahrens unter ein und demselben Fensterelement und somit in unmittelbarer räumlicher Nähe zueinander angeordnet sind.

Die Erfindung betrifft weiters eine nach dem erfindungsgemäßen Verfahren hergestellte Leiterplatte. Die nach dem erfindungsgemäßen Verfahren hergestellte Leiterplatte zeichnet sich bevorzugt dadurch aus, dass die zumindest eine Komponente unter einem an der Außenseite der Leiterplatte angeordneten Fensterelement angeordnet ist, wobei es jedoch nicht ausgeschlossen ist, dass für gewisse Anwendungen auch Fensterelemente mit darunter angeordneten optoelektronischen Komponenten im Inneren einer Leiterplatte von Nutzen sein können.

Die Erfindung wird nachfolgend anhand eines in der Zeichnung schematisch dargestellten

Ausführungsbeispiels näher erläutert. Falls der Wortlaut "eine Variante der vorliegenden Erfindung" oder "Ausführungsform der vorliegenden Erfindung" im Rahmen eines Produkts verwendet wird, so bedeutet dies eine nach dem erfindungsgemäßen Verfahren hergestellte Leiterplatte.

In dieser zeigen
die Fig. 1a) bis 1g) eine bevorzugte Variante des erfindungsgemäßen Verfahrens,
die Fig. 2a) bis 2c) unterschiedliche, nach dem erfindungsgemäßen Verfahren hergestellte Leiterplatten,
die Fig. 3a) und 3b) weitere Ausführungsformen der vorliegenden Erfindung, unter Verwendung einer Mehrzahl von optoelektronischen Komponenten sowie
die Fig. 4a) bis 4c) eine bevorzugte Ausführungsform der vorliegenden Erfindung unter Verwendung eines DLP-Bauteils.

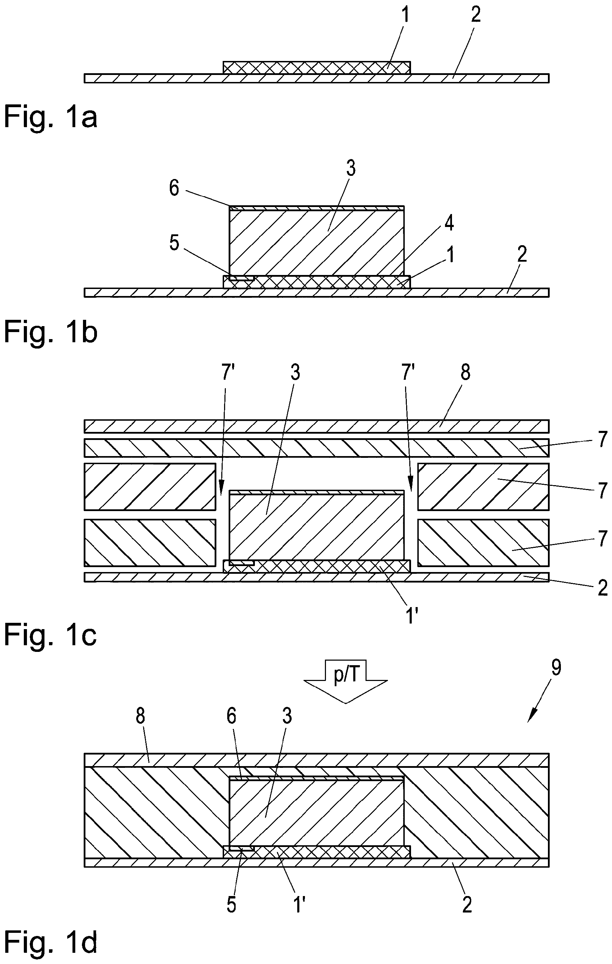

In Fig. 1a) wurde gemäß Schritt a) des erfindungsgemäßen Verfahrens eine transparente aushärtbare Klebeschicht 1 auf eine Trägerschicht 2, in diesem Fall auf eine Kupferlage 2 aufgebracht. Gemäß Schritt b) dieses erfindungsgemäßen Verfahrens wird nun eine in den Figuren stark schematisiert dargestellte optoelektronische Komponente 3 mit ihrer optisch relevanten Seite 4 auf die Klebeschicht 1 aufgesetzt, wobei mit 5 und 6 Kontakte der optoelektronischen Komponente 3 bezeichnet sind. In diesem Beispiel ist bei der optoelektronischen Komponente 3 vor allem an eine LED, eine Laserdiode oder an eine Photodiode gedacht. Die Klebeschicht 1 ermöglicht die temporäre Positionierung der Komponente 3, bis die transparent aushärtbare Klebeschicht 1 zu einem Fensterelement 1' ausgehärtet wurde und die Komponente 3 dauerhaft in den Leiterplattenverbund eingebettet ist. In Fig. 1c) ist nun dargestellt, dass die optoelektronische Komponente 3 nach dem Aushärten der transparent aushärtbaren Klebeschicht 1 zum Fensterelement 1' in einen Leiterplattenverbund eingebettet wird, wie dies Schritt d) des erfindungsgemäßen Verfahrens entspricht. Zum Einbetten der Komponente 3 werden die Lagen aus einem glasfaserverstärkten Epoxidharz 7 verwendet, die zur Aufnahme der optoelektronischen Komponente 3 entsprechende Freistellungen 7' aufweisen. Derartige Lagen aus glasfaserverstärkten Epoxidharz werden auch als Prepregs bezeichnet. Über den Lagen aus glasfaserverstärktem Epoxidharz (Prepreg-Material) wird eine weitere Lage aus glasfaserverstärktem Epoxidharz 7 aufgelegt, die wiederum von einer Kupferlage 8 abgedeckt wird. Das glasfaserverstärkte Epoxidharz wird durch Anwenden von Druck und Temperatur ausgehärtet, wie dies in Fig. 1d) versinnbildlicht ist. Im ausgehärteten Zustand umgibt das ausgehärtete Epoxidharz des Prepreg-Materials die optoelektronische Komponente 3 vollständig und sorgt für einen festen Verbund der Leiterplatte 9. In Fig. 1d) ist das Fensterelement 1' noch unter der Trägerschicht 2 verborgen.

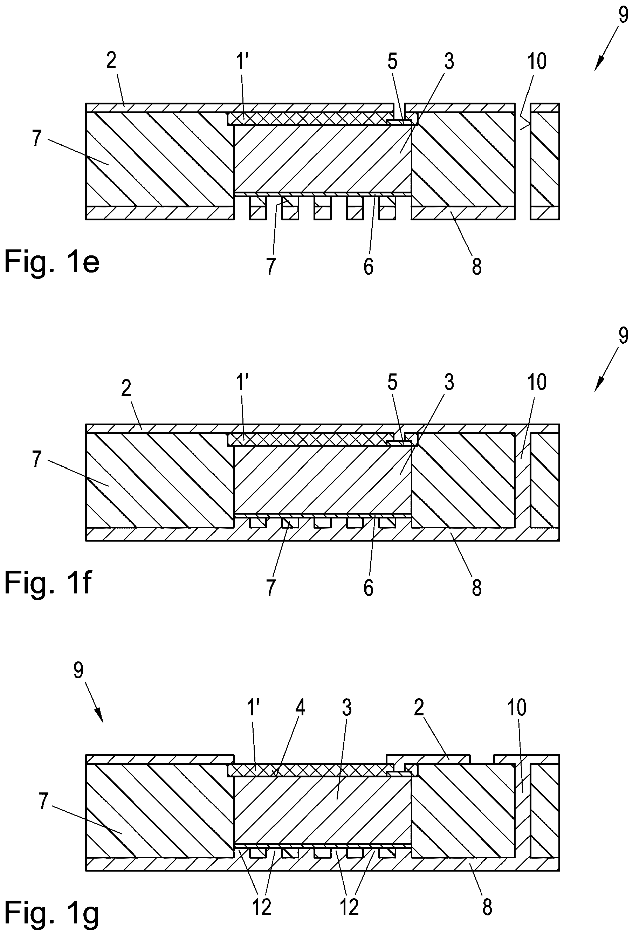

In Fig. 1e) ist zu erkennen, dass die Kontakte 5 und 6 der Komponente 3 durch Strukturieren der Trägerschicht 2 bzw. der Kupferlage 8 sowie des Fensterelements 1' und des unter der Kupferlage 8 liegenden Prepreg-Materials 7 freigelegt werden, was durch mechanische Bohrverfahren oder auch durch Laserbohren erfolgen kann. Das Bezugszeichen 10 bezeichnet eine Durchgangsbohrung durch die Leiterplatte 9, die ebenfalls zur Verschaltung der Komponente 3 sowie eventuell vorhandener weiterer Komponenten dient. Nach dem in Fig. 1e) dargestellten Bohren erfolgt eine galvanische Verkupferung der Leiterplatte 9, was zum Auffüllen der Bohrungen, die in Fig. 1e) zu erkennen sind, führt, so dass die Kontakte 5 und 6 nun thermisch und elektrisch leitend mit den Kupferlagen 2 und 8 verbunden sind (Fig. 1f)). Noch immer gemäß dem Verfahrensschritt e) des vorliegenden Verfahrens erfolgt die weitere Strukturierung der galvanisch verkupferten Trägerschicht bzw. Kupferlage 2 zur großflächigen Freilegung des Fensterelements 1' im Bereich, der mit dem Bezugszeichen 11 bezeichnet ist. Die optoelektronische Komponente 3 ist nun vollständig in die Leiterplatte 9 eingebettet, durch die Kupferlage 2 und durch die Kupferlage 8 thermisch und elektrisch ankontaktiert und unter einem an der Außenseite der Leiterplatte 9 angeordneten Fensterelement 1' angeordnet. Auf diese Weise kann die optisch relevante Seite 4 der optoelektronischen Komponente 3 mit der Umgebung der Leiterplatte kommunizieren und Licht in die Umgebung abstrahlen bzw. Licht aus der Umgebung empfangen. In dem in der Fig. 1 gezeigten Beispiel dient die Ankontaktierung im Bereich des Kontaktes 6 der optoelektronischen Komponente vor allem der thermischen Verbindung der optoelektronischen Komponente 3 mit der Kupferlage 8, wobei durch die Vias 12 eine überaus effiziente Abfuhr von Wärme in die Kupferlage 8 erfolgt. Wenn als optoelektronische Komponente 3 eine LED vorgesehen ist, kann es gemäß einer bevorzugten Ausführungsform der vorliegenden Erfindung vorgesehen sein, die Klebeschicht 1 vor dem Aufsetzen der Komponente mit einem Lichtkonversionsmittel zu versehen, welches nach dem Aushärten der Klebeschicht 1 gleichmäßig verteilt im Fensterelement 1' vorliegt und eine Konversion des Lichts bewirkt.

Das Aushärten der Klebeschicht kann im Zustand gemäß der Fig. 1b durch Anwendung von UV-Licht und/oder erhöhter Temperatur erfolgen.

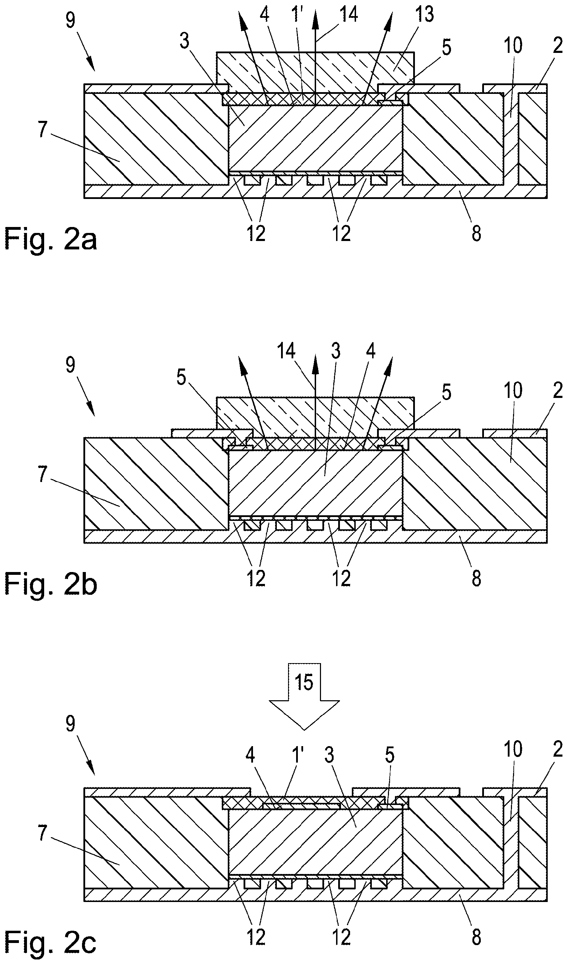

In Fig. 2a) ist eine Variante der vorliegenden Erfindung gezeigt, bei der eine transparente Schicht 13, die mit einem Lichtkonversionsmittel versehen ist, auf dem Fensterelement 1' angeordnet ist. Diese Anwendung ist insbesondere dann sinnvoll, wenn die optoelektronische Komponente 3 eine LED ist, die das Licht, welches durch die Schar von Pfeilen 14 versinnbildlicht ist, durch die transparente Schicht 13 abstrahlt. In Fig. 2a) ist lediglich ein Kontakt 5 auf der optisch relevanten Seite 4 der optoelektronischen Komponente 3 dargestellt, in welchem Fall die elektrische Ankontaktierung der Komponente 3 über den Kontakt 6, die Vias 12 und die Kupferlage 8 erfolgt. In Fig. 2b) ist eine Variante dargestellt, bei der zwei Kontakte 5 an der optisch relevanten Seite 4 der optoelektronischen Komponente 3 angeordnet sind. Die optoelektronische Komponente 3 wird somit elektrisch nur an der optisch relevanten Seite 4 ankontaktiert.

In Fig. 2c) ist eine Variante der vorliegenden Erfindung dargestellt, bei der die optoelektronische Komponente 3 eine Photodiode ist, deren optisch relevante Seite wiederum mit 4 bezeichnet ist. Der Pfeil 15 symbolisiert einfallendes Licht, welches durch das Fensterelement 1' hindurchtritt und von der optisch relevanten Seite 4 der optoelektronischen Komponente 3 detektiert wird. In dem in Fig. 2c) gezeigten Beispiel ist die optoelektronische Komponente 3 bzw. Photodiode 3 durch einen Kontakt 5 auf der optisch relevanten Seite 4 und durch Vias 12 auf der gegenüberliegenden Seite, d.h. auf der Seite der Kupferlage 8 ankontaktiert. Diese rückseitige Kontaktierung stellt nicht nur eine elektrische Verbindung, sondern auch eine sehr effiziente thermische Verbindung zur Kupferlage 8 her.

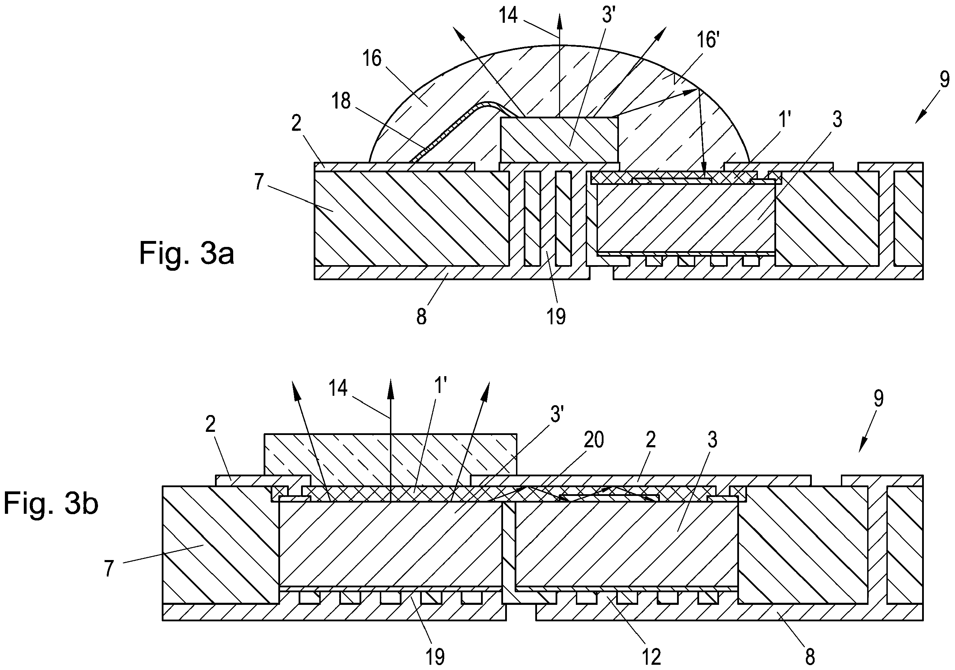

In Fig. 3a) ist eine Variante der mit dem erfindungsgemäßen Verfahren hergestellten Leiterplatte gezeigt, die zwei optoelektronische Komponenten 3 und 3' aufweist. Die lichtemittierende Komponente 3', beispielsweise eine LED, emittiert Licht, das durch die Schar von Pfeilen 14 dargestellt ist und ist hierbei in einem Kunststoffkörper 16 eingelassen, der das Fensterelement 1' überragt. An der Grenzfläche 16' zwischen Kunststoffkörper 16 und Umgebung 17 der Leiterplatte 9 wird ein Teil des ausgestrahlten Lichts reflektiert, welches auf die optoelektronische Komponente 3 fällt und dort detektiert wird. In dem in Fig. 3a) gezeigten Beispiel ist die optoelektronische Komponente 3 eine Photodiode, kann jedoch auch ein DLP-Bauteil sein. Mit 18 ist ein Bonddraht bezeichnet, über den die optoelektronische Komponente 3' mit der Kupferlage 2 elektrisch verbunden ist. Über Vias 19 erfolgt die weitere Ankontaktierung der optoelektronischen Komponente 3', wobei die Vias 19 neben der elektrischen Ankontaktierung auch eine thermische Kontaktierung der optoelektronischen Komponente 3' zur Kupferlage 8 zur Verfügung stellen.

In Fig. 3b) ist eine Variante der vorliegenden Erfindung gezeigt, bei der beide optoelektronische Komponenten und insbesondere eine Lichtemittierende optoelektronische Komponente 3' und eine lichtdetektierende Komponente 3 auf die Klebeschicht 1 aufgesetzt wurden. Folglich sind die beiden Komponenten 3' und 3 unter einem gemeinsamen Fensterelement 1' angeordnet, wobei das Fensterelement 1' im Bereich der lichtdetektierenden Komponente 3 von der Trägerschicht bzw. der Kupferlage 2 bedeckt ist. Wie durch die Pfeile 20 versinnbildlicht, koppelt ein Teil des von der optoelektronischen Komponente 3 abgestrahlten Lichts in das Fensterelement 1' ein und wird von der lichtdetektierenden Komponente 3 detektiert.

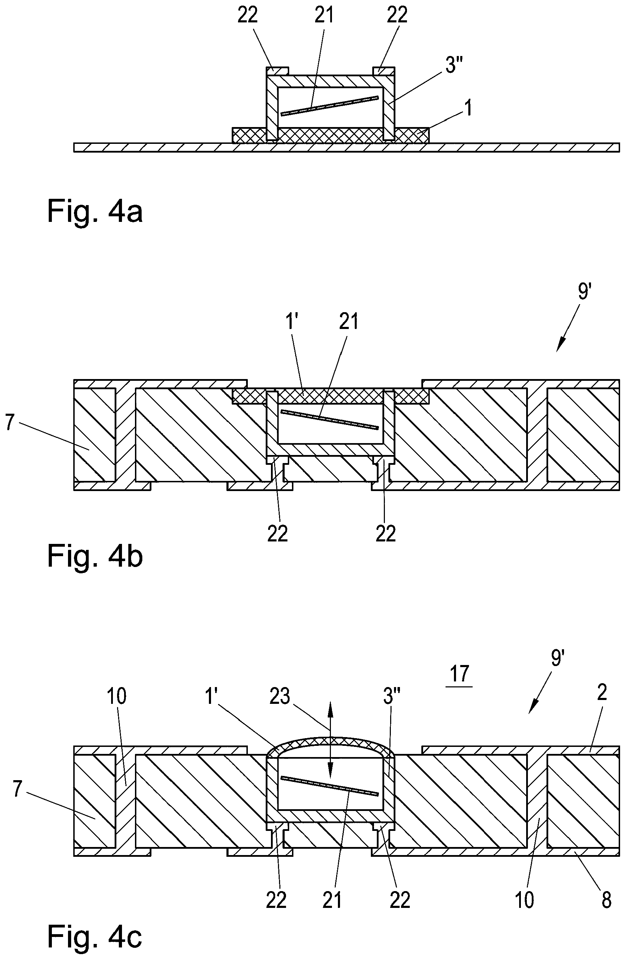

In Fig. 4a) ist die Anwendung des erfindungsgemäßen Verfahrens auf ein DLP-Bauteil 3" dargestellt. DLP-Bauteile weisen bewegliche Teile auf, was in der Fig. 4a) durch einen Spiegel 21 dargestellt ist. Der DLP-Bauteil 3" weist mit 22 bezeichnete Kontakte auf. Im vorliegenden Fall ist das DLP-Bauteil 3" hohl und offen, wobei jedoch aufgrund der überaus geringen Schichtdicke der Klebeschicht 1, die in einer Dicke von 5 µm bis 50 µm aufgebracht wird, keine Beeinträchtigung einer oszillierenden Bewegung des Spiegels 21 zu befürchten ist. Die Weiterverarbeitung zur fertigen Leiterplatte erfolgt wie im Zusammenhang mit den Fig. 1c) bis 1g) erläutert, sodass eine Leiterplatte 9' erhalten wird, die über galvanisch verkupferte Kontakte 22 und ein freigelegtes Fensterelement 1' verfügt. Das Fensterelement 1' ist zwar mechanisch und chemisch überaus stabil, kann sich jedoch bei Bedarf in Richtung des Doppelpfeils 23 wölben, um eventuell einen Druckausgleich zwischen dem Hohlraum im Inneren des DLP-Bauteils 3" und der Umgebung 17 herzustellen. Die soeben beschriebene Variante ist jedoch nicht auf die Verwendung von DLP-Bauteilen beschränkt, sondern kann aufgrund der Flexibilität des Fensterelements 1' auch zur Integration von Drucksensoren oder ähnlichen Bauteilen Anwendung finden.

## Patentansprüche

1. Verfahren zur Herstellung einer Leiterplatte mit zumindest einer optoelektronischen Komponente mit den folgenden Schritten:
a) Aufbringen einer transparent aushärtbaren Klebeschicht (1) auf eine Trägerschicht (2),
b) Aufsetzen zumindest einer optoelektronischen Komponente (3) mit einer optisch relevanten Seite (4) der Komponente auf die Klebeschicht (1),
c) Aushärten der Klebeschicht (1) zu einem Fensterelement (1'),
d) Einbetten der Komponente (3) in einen Leiterplattenverbund,
e) Strukturieren der Trägerschicht (2) zur zumindest teilweisen Freilegung des Fensterelements (1') und zur Ankontaktierung der Komponente (3).

2. Verfahren nach Anspruch 1, **dadurch gekennzeichnet, dass** die optoelektronische Komponente (3) aus der Gruppe bestehend aus einer Laserdiode, einer LED, einer Photodiode und einem DLP-Bauteil gewählt wird.

3. Verfahren nach Anspruch 1 oder 2, **dadurch gekennzeichnet, dass** das Material für die transparent aushärtbare Klebeschicht (1) aus der Gruppe bestehend aus Epoxidharz, Polysiloxan, Ormocer und Lötstopplack gewählt wird.

4. Verfahren nach einem der Ansprüche 1 bis 3, **dadurch gekennzeichnet, dass** die Klebeschicht (1) mit einer Dicke von 5 µm bis 50 µm aufgebracht wird.

5. Verfahren nach einem der Ansprüche 1 bis 4, **dadurch gekennzeichnet, dass** das Aufbringen der Klebeschicht (1) mit einem Verfahren erfolgt, welches aus der Gruppe bestehend aus Siebdruck-Verfahren, Inkjet-Verfahren und Rakel-Verfahren gewählt wird.

6. Verfahren nach einem der Ansprüche 1 bis 5, **dadurch gekennzeichnet, dass** die Trägerschicht (2) von einer Kupferlage (2) mit einer Dicke von 1 µm bis 5 µm, insbesondere 2 µm, gebildet ist.

7. Verfahren nach einem der Ansprüche 1 bis 6, **dadurch gekennzeichnet, dass** die Trägerschicht (2) beim Schritt des Aufsetzens der Komponente (3) mit einer Stützschicht verbunden ist.

8. Verfahren nach einem der Ansprüche 1 bis 7, **dadurch gekennzeichnet, dass** das Aushärten der Klebeschicht (1) unter Anwendung von UV-Licht und/oder erhöhter Temperatur ausgeführt wird.

9. Verfahren nach einem der Ansprüche 1 bis 7, **dadurch gekennzeichnet, dass** die Komponente (3) in zumindest eine Lage aus einem glasfaserverstärkten Epoxidharz (7) mit einer der Komponente (3) entsprechenden Ausnehmung (7') eingebettet wird.

10. Verfahren nach einem der Ansprüche 1 bis 9, **dadurch gekennzeichnet, dass** die transparent aushärtbare Klebeschicht (1) vor dem Aufsetzen der Komponente (3) mit einem Lichtkonversionsmittel versetzt wird.

11. Verfahren nach einem der Ansprüche 1 bis 9, **dadurch gekennzeichnet, dass** nach dem Freilegen des Fensterelements (1') eine transparente Schicht (13) mit einem Lichtkonversionsmittel auf das Fensterelement (1') aufgebracht wird.

12. Verfahren nach einem der Ansprüche 1 bis 11, **dadurch gekennzeichnet, dass** zumindest zwei optoelektronische Komponenten (3,3'), insbesondere eine lichtemittierende und eine lichtdetektierende Komponente auf die Klebeschicht aufgesetzt werden.

## Claims

1. Method for producing a printed circuit board with at least one optoelectronic component, having the following steps:
a) Applying a transparently curable adhesive layer (1) to a carrier layer (2),
b) Placing at least one optoelectronic component (3) with an optically relevant side (4) of the component on the adhesive layer (1),
c) Curing the adhesive layer (1) to form a window element (1'),
d) Embedding the component (3) in a printed circuit board composite,
e) Structuring the carrier layer (2) in order to at least partially expose the window element (1') and for contacting the component (3).

2. Method according to claim 1, **characterized in that** the optoelectronic component (3) is selected from the group consisting of a laser diode, an LED, a photodiode and a DLP device.

3. Method according to claim 1 or 2, **characterized in that** the material for the transparent curable adhesive layer (1) is selected from the group consisting of epoxy resin, polysiloxane, ormacrylate, polysiloxane, ormocer and solder resist.

4. Method according to any one of claims 1 to 3, **characterized in that** the adhesive layer (1) is applied with a thickness of 5µm to 50µm.

5. Method according to one of claims 1 to 4, **characterised in that** the application of the adhesive layer (1) is carried out by a method selected from the group consisting of screen printing method, inkjet method and squeegee method.

6. Method according to any one of claims 1 to 5, **characterized in that** the carrier layer (2) is formed by a copper layer (2) with a thickness of 1µm to 5µm, in particular 2µm, is formed.

7. Method according to any one of claims 1 to 6, **characterized in that** the support layer (2) is connected to a support layer during the step of placing the component (3).

8. Method according to any one of claims 1 to 7, **characterized in that** the curing of the adhesive layer (1) is carried out using UV light and/or elevated temperature.

9. Method according to any one of claims 1 to 7, **characterised in that** the component (3) is embedded in at least one layer of a glass fibre-reinforced epoxy resin (7) with a recess (7') corresponding to the component (3).

10. Method according to any one of claims 1 to 9, **characterized in that** a light conversion agent is added to the transparently curable adhesive layer (1) before the component (3) is placed thereon.

11. Method according to any one of claims1 to 9, **characterised in that**, after the window element (1') has been exposed, a transparent layer (13) is applied to the window element (1') with a light conversion agent.

12. Method according to any one of claims 1 to 11, **characterised in that** at least two optoelectronic components (3, 3'), in particular a light-emitting component and a light-detecting component, are placed on the adhesive layer.

## Revendications

1. Procédé de fabrication d'une carte de circuit imprimé avec au moins un composant optoélectronique, comprenant les étapes suivantes :
a) Application d'une couche adhésive (1) durcissable de façon transparente sur une couche de support (2),
b) Mise en place d'au moins un composant optoélectronique (3) avec une partie optiquement côté pertinent (4) du composant sur la couche adhésive (1),
c) Durcissement de la couche adhésive (1) pour former un élément de fenêtre (1'),
d) Incorporation du composant (3) dans un assemblage de circuits imprimés,
e) Structuration de la couche de support (2) afin de dégager au moins partiellement l'élément de fenêtre (1') et d'établir le contact avec le composant (3).

2. Procédé selon la revendication 1, **caractérisé en ce que** le composant optoélectronique est choisi parmi les éléments suivants 2. le composant (3) est choisi dans le groupe constitué par une diode laser, une DEL, une photodiode et un composant DLP.

3. Procédé selon la revendication 1 ou 2, **caractérisé en ce que** le matériau pour la couche adhésive (1) durcissable par transparence est choisi dans le groupe constitué par la résine époxy, le polysiloxane, l'Ormocer et le vernis épargne.

4. Procédé selon l'une des revendications 1 à 3, **caractérisé en ce que** la couche adhésive (1) est appliquée avec une épaisseur de 5 µm à 50 µm.

5. Procédé selon l'une des revendications 1 à 4, **caractérisé en ce que** l'application de la couche adhésive (1) est réalisée par un procédé choisi dans le groupe constitué par le procédé de sérigraphie, le procédé de jet d'encre et le procédé de raclage.

6. Procédé selon l'une quelconque des revendications 1 à 5, **caractérisé en ce que** la couche de support (2) est constituée d'une couche de cuivre (2) d'une épaisseur de 1µm à 5µm, notamment de 2µm, est formée.

7. Procédé selon l'une quelconque des revendications 1 à 6, **caractérisé en ce que** la couche de cuivre est déposée sur le substrat. couche de support (2) est reliée à une couche de soutien lors de l'étape de mise en place du composant (3)

8. Procédé selon l'une des revendications 1 à 7, **caractérisé en ce que** le durcissement de la couche adhésive (1) est réalisé en utilisant de la lumière UV et/ou une température élevée.

9. Procédé selon l'une des revendications 1 à 7, **caractérisé en ce que** le composant (3) est noyé dans au moins une couche d'une résine époxy (7) renforcée par des fibres de verre et présentant un évidement (7') correspondant au composant (3).

10. Procédé selon l'une des revendications 1 à 9, **caractérisé en ce que** la couche adhésive (1) durcissable par transparence est additionnée d'un agent de conversion à la lumière avant la mise en place du composant (3).

11. Procédé selon l'une quelconque des revendications 1 à 9, **caractérisé en ce que**, après avoir dégagé l'élément de fenêtre (1'), une couche transparente (13) est appliquée sur l'élément de fenêtre (1') à l'aide d'un agent de conversion de lumière.

12. Procédé selon l'une des revendications 1 à 11, **caractérisé en ce qu'**au moins deux composants optoélectroniques (3, 3'), notamment un composant émettant de la lumière et un composant détectant la lumière, sont appliqués sur la couche adhésive.
